(19) Europäisches Patentamt / European Patent Office / Office européen des brevets

(11) **EP 2 226 412 B1**

(12) **EUROPEAN PATENT SPECIFICATION**

(45) Date of publication and mention
of the grant of the patent:
**04.04.2012 Bulletin 2012/14**

(51) Int Cl.:
*C30B 15/20* $^{(2006.01)}$    *C30B 29/06* $^{(2006.01)}$
*C30B 33/02* $^{(2006.01)}$    *H01L 21/322* $^{(2006.01)}$

(21) Application number: **10153672.0**

(22) Date of filing: **16.02.2010**

(54) **Method for growing silicon single crystal and method for producing silicon wafer**

Verfahren zur Herstellung eines Siliciumeinkristalls und Verfahren zur Herstellung eines Siliciumwafers

Procédé de croissance de silicium monocristallin et procédé de fabrication d'une tranche de silicium

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **27.02.2009 JP 2009046244**

(43) Date of publication of application:
**08.09.2010 Bulletin 2010/36**

(73) Proprietor: **SUMCO Corporation
Minato-ku
Tokyo (JP)**

(72) Inventors:
• **Murakami, Hiroki
Tokyo (JP)**
• **Kato, Koji
Tokyo (JP)**

(74) Representative: **Cabinet Plasseraud et al
52, rue de la Victoire
75440 Paris Cedex 09 (FR)**

(56) References cited:
**EP-A1- 1 270 769**    **EP-A1- 1 598 452**
**WO-A1-03/091484**    **US-A1- 2007 193 501**
**US-B1- 6 547 875**

**Description**

BACKGROUND OF THE INVENTION

1. Field of the Invention

The present invention relates to a method for growing a silicon single crystal by the Czochralski process to produce a silicon wafer suitable for an insulated gate bipolar transistor and a method for producing a silicon wafer whose inside defects have been reduced.

2. Description of the Related Art

In recent years, the development etc. of an insulated gate bipolar transistor (hereinafter referred to as an "IGBT") has been pursued. Unlike an LSI, such as a memory, which is an element using only an area near the front surface of a wafer (only the lateral direction of the wafer), since the IGBT is an element which uses also the thickness direction of the wafer (the vertical direction of the wafer), the characteristics thereof are influenced by the quality inside the wafer. Therefore, it is necessary to reduce not only COPs (crystal originated particles: vacancy-type agglomerated defects) and oxygen precipitates which are present in a wafer surface layer, but also COPs and oxygen precipitates inside the wafer.

Conventionally, a silicon wafer for an IGBT and a method for producing the same are disclosed in Patent Documents 1 and 2, for example. Patent Document 1 discloses a silicon single crystal wafer for an IGBT, the silicon single crystal wafer whose variation in resistivity in a plane of the silicon wafer obtained by slicing a silicon single crystal is 5 % or less, the silicon single crystal grown by the Czochralski process (hereinafter referred to as the "CZ process") in an atmosphere of hydrogen gas, the silicon single crystal in which COPs and dislocation clusters are removed in the entire radial region thereof and the concentration of interstitial oxygen is $8.5 \times 10^{17}$ atoms/cm$^3$ or below. In the above-structured silicon single crystal wafer for an IGBT, the COPs and the dislocation clusters are removed in the entire radial region of the silicon single crystal, and therefore this silicon single crystal wafer is suitable as a wafer for an IGBT which is an element using the wafer in the vertical direction. That is, since the COPs and the dislocation clusters are removed in the entire radial region of the silicon single crystal, there is no possibility that the COPs are taken up by a gate oxide film at the time of formation of the gate oxide film on the front surface of a wafer in the IGBT production process, and this helps prevent the GOI (gate oxide integrity: the withstand voltage characteristics of the gate oxide film) from being degraded. Moreover, as a result of the dislocation clusters being removed, it is possible to prevent a leakage current in an integrated circuit.

On the other hand, Patent Document 2 discloses a method for producing a silicon wafer, the method by which a silicon wafer obtained by slicing a silicon single crystal is subjected to heat treatment in an oxidizing atmosphere. In this production method, when a temperature at which the silicon wafer is subjected to heat treatment in an oxidizing atmosphere is set at T°C and the concentration of interstitial oxygen of the silicon wafer is set at [Oi] atoms/cm$^3$, heat treatment is performed such that the relationship between the temperature T and the concentration [Oi] of interstitial oxygen satisfies the following inequality (1).

$$[Oi] \leq 2.123 \times 10^{21} exp(-1.035/k(T+273)) \qquad (1)$$

In the inequality (1) above, the concentration [Oi] of interstitial oxygen is a value measured by FT-IR (ASTM F-121, 1979), and k is the Boltzmann constant (= $8.617 \times 10^{-5}$ eV/K). Moreover, as the silicon single crystal, a single crystal doped with phosphorus by irradiation with neutrons is used. In the silicon wafer produced as described above, when the heat treatment temperature T is set such that the heat treatment temperature T and the concentration [Oi] of interstitial oxygen satisfies the relationship described above in performing heat treatment on the silicon wafer in an oxidizing atmosphere, interstitial silicon atoms which have appeared on the front surface of the silicon wafer as a result of the oxidizing heat treatment are diffused into the silicon wafer and fill the COPs which are voids. This makes it possible to eliminate the COPs throughout the entire area of the silicon wafer from shallow to deep depths. Moreover, since a silicon single crystal is grown without doping the crystal with dopant such as phosphorus and then the silicon single crystal is doped with phosphorus by irradiation with neutrons, it is possible to make uniform the specific resistance in the direction of a growth axis of the silicon single crystal.

Patent Document

[Patent Document 1] Japanese Unexamined Patent Application Publication No. 2007-254274 (claim 1, paragraph

**[0007]** )

[Patent Document 2] WO 2004/073057 (claims 1 and 2, page 5, lines 9 to 17 and page 5, lines 22 to 26 of the specification)

## SUMMARY OF THE INVENTION

However, the conventional silicon single crystal wafer for an IGBT, the silicon single crystal wafer described in Patent Document 1, has the following problem. It is true that, in this silicon single crystal wafer, the range of an allowable pulling rate for obtaining a region with no grow-in defects (the defect-free margin) is widened as a result of a silicon single crystal being grown in an atmosphere of hydrogen gas; however, in order to obtain a silicon single crystal with no grow-in defects, the silicon single crystal from which COPs and dislocation clusters are removed, as in the conventional growth of a silicon single crystal in an atmosphere of argon gas, it is necessary to slow down the pulling rate. This results in a reduction in productivity. Moreover, the problem is that, when a silicon single crystal is grown in an atmosphere of hydrogen gas under the condition where COPs appear, a giant cavity defect called a hydrogen defect appears in a region where the COPs appear.

On the other hand, it is true that, in the conventional method for producing a silicon wafer, the method described in Patent Document 2, a silicon wafer with uniform resistivity in the radial and axial directions of a single crystal can be obtained by growing a silicon single crystal without doping the crystal with phosphorus or the like and irradiating the silicon single crystal with neutrons, and the neutron irradiation technique is an effective method for making the dopant concentration uniform. However, neutron irradiation has to be conducted by using a nuclear reactor such as a heavy-water reactor, and there are few institutions in the world, which can perform such treatment. For this reason, when neutron irradiation is adopted, it is expected that product wafers cannot be •industrially mass-produced. Moreover, it is necessary to perform heat treatment to undo the irradiation damage to the single crystal caused by the neutron irradiation, leading to an increase in production costs. In addition, the problem of the neutron irradiation is that only a single crystal doped with phosphorus can be produced by irradiation with neutrons.

Moreover, it is true that, in the conventional method for producing a silicon wafer, the method described in Patent Document 2, the concentration of oxygen in a silicon wafer and the condition of subsequent oxidizing heat treatment are adjusted such that the relationship between a particular concentration of interstitial oxygen and a particular oxidizing heat treatment temperature is satisfied, whereby it is possible to eliminate COPs not only in a wafer surface layer, but also throughout the entire area of a wafer. However, the problem is that, when COPs which are originally present in a single crystal are large in size or the COPs are present at high densities, it is impossible to eliminate the COPs completely even by performing oxidizing heat treatment.

On the other hand, as a silicon single crystal wafer for an IGBT, a silicon wafer in which the concentration of oxygen is reduced to a lower level than ever before and the in-plane resistance distribution is uniform is required to be provided. As a technique to reduce the concentration of oxygen in a silicon single crystal, it was previously known that, by applying a horizontal magnetic field to silicon melt and slowing down the rotation speed of a crucible, the amount of oxygen taken up in the silicon melt from the crucible could be reduced, thereby lowering the concentration of interstitial oxygen in a single crystal. However, the experiment conducted by the inventors has revealed that, by only applying a horizontal magnetic field to silicon melt and slowing down the rotation speed of a crucible, it is impossible to grow a silicon single crystal containing a very low concentration of oxygen, such as an interstitial oxygen concentration of 6.0 $\times$ $10^{17}$ atoms/cm$^3$ or below. Furthermore, although it is known that the in-plane dopant concentration (resistivity distribution) of a silicon single crystal is uniformized when the rotation speed of the silicon single crystal is increased, the problem is that the increased rotation speed of the single crystal results in an elevated oxygen concentration. However, the inventors have found that, under the growth condition where the shape of the solid-liquid interface between a single crystal and silicon melt is flattened, even when the rotation speed of the single crystal is slowed down, the dopant concentration distribution in the radial direction of the single crystal is not worsened, and it is possible to reduce the concentration of interstitial oxygen to a lower level.

An object of the present invention is to provide a method for growing a silicon single crystal, the method that eliminates the need to irradiate a silicon single crystal with neutrons, that can make the range of the pulling rate of a single crystal relatively wide, and that can reduce variation in radial in-plane resistivity in the silicon single crystal.

Another object of the present invention is to provide a method for producing a silicon wafer, the method that can eliminate COPs throughout the entire area of a wafer in the radial and thickness directions by performing oxidizing heat treatment on a silicon wafer obtained by slicing a silicon single crystal.

A first aspect in accordance with the present invention is directed to a method for growing a silicon single crystal, the method by which silicon melt is stored in a crucible housed in a chamber under inert gas and a silicon single crystal is grown from a seed crystal by immersing the seed crystal in the silicon melt and pulling the seed crystal upward therefrom while rotating the seed crystal, wherein the silicon melt stored in the crucible contains n-type dopant, the concentration of interstitial oxygen in the silicon single crystal is $6.0 \times 10^{17}$ atoms/cm$^3$ or below, variation in radial in-plane resistivity of the silicon single crystal is 5 % or less, and the silicon single crystal includes a region where COPs have appeared, the COPs having a size of 100 nm or less and a density of $3 \times 10^6$ counts/cm$^3$ or below.

The silicon single crystal is grown under the condition satisfying the relation Gc/Ge ≥ 1 when, the temperature gradients in the pulling direction of the silicon single crystal being in the temperature range where the temperature of the center of the silicon single crystal during growth is from the melting point to 1370°C, the temperature gradient at the center of the silicon single crystal during growth is Gc and the temperature gradient on the periphery of the silicon single crystal during growth is Ge.

A horizontal magnetic field of 0.2 T or more is applied to the silicon melt in the crucible, the rotation speed of the crucible is 1.5 rpm or less, and the rotation speed of the silicon single crystal during growth is 7 rpm or less.

A second aspect in accordance with the present invention is directed to a method for producing a silicon wafer, wherein COPs are eliminated throughout the entire area of the silicon wafer by performing heat treatment on a silicon wafer obtained by slicing a silicon single crystal grown by the method according to any one of the first to third aspects, the heat treatment by which the silicon wafer is heated in an atmosphere of oxygen gas to a predetermined temperature in the range of 1100 to 1300°C and is maintained at the predetermined temperature for 2 to 5 hours.

In the growth method according to the present invention, a silicon single crystal is pulled upward from the silicon melt containing n-type dopant by using the CZ process. This eliminates the need to irradiate the silicon single crystal with neutrons. As a result, it is possible to solve the following problem, which arises when the single crystal is doped with phosphorus by irradiation with neutrons. That is, when the single crystal is doped with phosphorus by irradiation with neutrons, the single crystal is produced with extremely low productivity, making it impossible to supply the market with a sufficient quantity of single crystals, or it is necessary to perform treatment to undo the damage to the single crystal caused by the neutron irradiation. Moreover, since the method is designed for a crystal region including a region where COPs having a predetermined size and density have appeared, it is possible to solve the following problem associated with a non-defect single crystal. That is, a non-defect single crystal is produced with lower productivity, or it becomes difficult to perform single crystal growth control due to a narrow range of a permissible pulling rate.

In the growth method according to the present invention, by growing a silicon single crystal in such a way that a COP appears under the condition satisfying a relation Gc/Ge ≥ 1, it is possible to obtain a single crystal in which the COPs are small in size and the density thereof is low. When a single crystal is grown in such a way that a COP appears under the condition of the conventional growth method, the condition satisfying a relation Gc/Ge < 1, that is, when a single crystal is grown in a hot zone where cooling is performed at high speed by increasing the pulling rate, the hot zone suitable for reducing the size of the COP, the COPs in the single crystal becomes smaller in size, but the density thereof becomes high. As a result, in the single crystal grown in the conventional hot zone, it is impossible to eliminate the COPs throughout the entire area of the wafer in the radial and thickness directions by the subsequent oxidizing heat treatment. By contrast, in the single crystal grown in the hot zone according to the present invention, it is possible to eliminate the COPs throughout the entire area of the wafer in the radial and thickness directions by the subsequent oxidizing heat treatment.

In the growth method according to the present invention, a horizontal magnetic field is applied to the silicon melt, the rotation speed of the crucible is slowed down, and the rotation speed of the single crystal is slowed down. This makes it possible to reduce the concentration of interstitial oxygen in the single crystal while maintaining a uniform radial n-type dopant concentration distribution of the single crystal.

In the production method according to the present invention, the COPs in a silicon wafer obtained by slicing the silicon single crystal described above have a size of 100 nm or less and a density of $3 \times 10^6$ counts/cm$^3$ or below. Therefore, by performing predetermined oxidizing heat treatment on this wafer, it is possible to eliminate the COPs throughout the entire area of the wafer in the radial and thickness directions.

BRIEF DESCRIPTION OF THE DRAWINGS

FIG. 1 is a configuration diagram showing the longitudinal section of an apparatus used in a method for growing a silicon single crystal according to an embodiment of the invention;
FIG. 2 is a schematic diagram showing, in the left side thereof, a formation behavior of a crystal defect occurring in a silicon single crystal grown in a hot zone where cooling is performed at high speed, and, in the right side thereof, a formation behavior of a crystal defect occurring in a silicon single crystal grown in a hot zone suitable for the growth of a non-defect single crystal;

FIG. 3 is a graph showing the relationship between the sizes and density of light-scattering materials (COPs) in wafers of Comparative Examples 2 and 3;

FIG. 4 is a graph showing the relationship between the sizes and density of light-scattering materials (COPs) in wafers of Comparative Example 4 and Example 2;

FIG. 5 is a graph showing the yield of GOI before and after performing oxidizing heat treatment on wafers of Comparative Examples 2 and 3;

FIG. 6 is a graph showing the yield of GOI before and after performing oxidizing heat treatment on wafers of Comparative Example 4 and Example 2;

FIG. 7 is a graph showing the yield of GOI before and after performing oxidizing heat treatment on wafers of Comparative Examples 5 and 6;

FIG. 8 is a graph showing the yield of GOI before and after performing oxidizing heat treatment on wafers of Examples 3 to 5;

FIG. 9 is a graph showing the oxygen concentration distribution in the direction in which a silicon single crystal of Example 6 is grown, the silicon single crystal grown in a hot zone suitable for the growth of a non-defect single crystal;

FIG. 10 is a graph showing the in-plane distribution of radial specific resistance in a silicon single crystal of Example 6, the silicon single crystal grown in a hot zone suitable for the growth of a non-defect single crystal; and

FIG. 11 is a graph showing the relationship among the rotation speed of a crucible, the rotation speed of a single crystal, and the concentration of interstitial oxygen.

DETAILED DESCRIPTION OF THE PREFERRED EMBODIMENTS

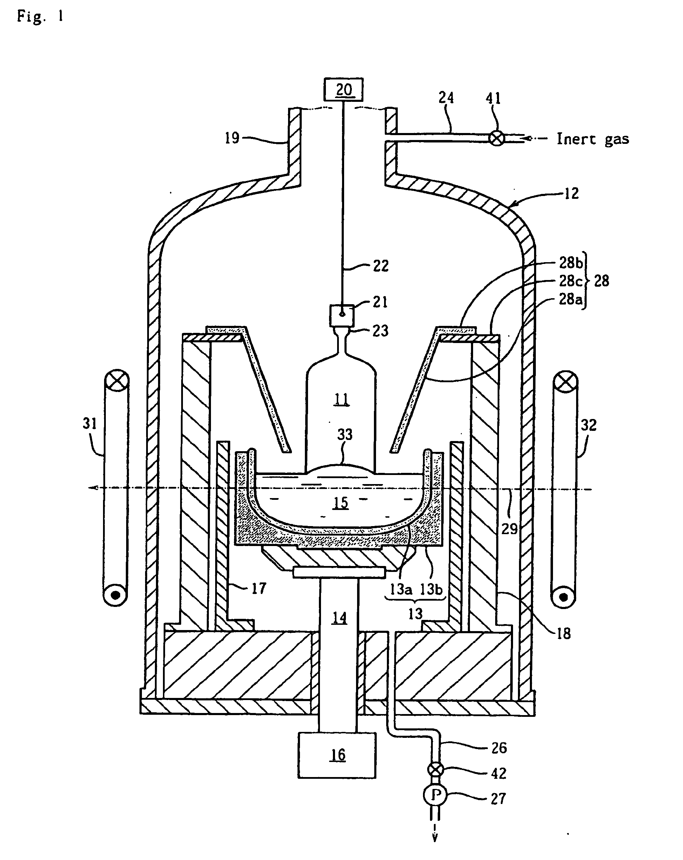

Next, an embodiment of the present invention will be described based on the drawings. As shown in FIG. 1, an apparatus for growing a silicon single crystal 11 includes a main chamber 12 that can be evacuated and a crucible 13 provided in the main chamber 12 in the center thereof. The main chamber 12 is a cylindrical vacuum vessel. Moreover, the crucible 13 is made up of a cylindrical inner case 13a with a bottom, the inner case 13a which is made of quartz and in which silicon melt 15 is stored, and a cylindrical outer case 13b with a bottom, the outer case 13b made of graphite and fitted around the outside of the inner case 13a. To the bottom of the outer case 13b, the upper end of a shaft 14 is connected. At the lower end of the shaft 14, a crucible driving unit 16, which rotates the crucible 13, and moves the crucible 13 up and down via the shaft 14 is provided. Furthermore, the outer circumferential surface of the crucible 13 is surrounded with a cylindrical heater 17 with a predetermined space left between the outer circumferential surface of the crucible 13 and the heater 17, and the outer circumferential surface of the heater 17 is surrounded with a cylindrical heat insulating tube 18 with a predetermined space left between the outer circumferential surface of the heater 17 and the heat insulating tube 18. Incidentally, the silicon melt 15 stored in the crucible 13 contains n-type dopant such as P (phosphorus), As (arsenic), or Sb (antimony).

On the other hand, to the upper end of the main chamber 12, a cylindrical pulling chamber 19 having a diameter smaller than that of the main chamber 12 is connected in such a way that the inside thereof is communicated with the inside of the main chamber 12. At the upper end of the pulling chamber 19, a pulling/rotating unit 20 is provided. The pulling/rotating unit 20 moves a pulling shaft 22 up and down, the pulling shaft 22 having a lower end to which a seed chuck 21 is attached, and rotates the pulling shaft 22 about a shaft line thereof. Moreover, to the seed chuck 21, a seed crystal 23 is detachably attached. After the lower end of the seed crystal 23 is immersed in the silicon melt 15, the seed crystal 23 is rotated and pulled upward by the pulling/rotating unit 20, and, at the same time, the crucible 13 is rotated and moved up by the crucible driving unit 16, whereby the silicon single crystal 11 is grown from the lower end of the seed crystal 23 by crystal pulling.

In the main chamber 12, inert gas such as argon gas is circulated. To the sidewall of the pulling chamber 19, one end of a gas supply pipe 24 is connected, and the other end of the gas supply pipe 24 is connected to a tank (not shown) in which the inert gas is stored. Moreover, to the lower wall of the main chamber 12, one end of a gas discharge pipe 26 is connected, and the other end of the gas discharge pipe 26 is connected to a suction port of a vacuum pump 27. The inert gas in the tank is introduced into the pulling chamber 19 through the gas supply pipe 24, passes through the main chamber 12, and is then discharged from the main chamber 12 through the gas discharge pipe 26. Incidentally, the gas supply pipe 24 and the gas discharge pipe 26 are provided with first and second flow regulating valves 41 and 42, respectively, which regulate the flow rate of the inert gas flowing through these pipes.

Moreover, in the main chamber 12, a heat shield 28 for preventing the outer circumferential surface of the silicon single crystal 11 from being irradiated with radiation heat from the heater 17 and guiding the flow of the inert gas is provided. The heat shield 28 has a cylindrical body 28a in the form of a circular truncated cone, the cylindrical body 28a having a diameter which becomes increasingly smaller from the top downward and surrounding the outer circumferential surface of the silicon single crystal 11 which is being pulled upward from the silicon melt 15 with a predetermined space left between the outer circumferential surface of the silicon single crystal 11 and the cylindrical body 28a, and a flange portion 28b which is continuously formed from the upper edge of the cylindrical body 28a and juts outward in an almost horizontal direction. The heat shield 28 is fixed in the main chamber 12 in such a way that the lower edge of the cylindrical body 28a is located above the surface of the silicon melt 15 with a predetermined gap between the lower edge of the cylindrical body 28a and the surface of the silicon melt 15 by placing the flange portion 28b on the heat insulating tube 18 with a ring plate 28c sandwiched between the flange portion 28b and the heat insulating tube 18. Furthermore, the apparatus is configured to pull the silicon single crystal 11 upward while applying a horizontal magnetic field 29 to the silicon melt 15. The horizontal magnetic field 29 is generated by disposing first and second coils 31 and 32 having the same coil diameter on the lateral sides located outside the outer circumferential surface of the crucible 13 with a predetermined space left between the outer circumferential surface of the crucible 13 and the lateral sides in the horizontal direction in such a way that the first and second coils 31 and 32 face each other with the crucible 13 placed in between, and passing current in the same direction through these coils 31 and 32.

A method for growing the silicon single crystal 11 by using the apparatus structured as described above will be described. First, the silicon melt 15 containing n-type dopant is obtained by adding n-type dopant such as P (phosphorus), As (arsenic), or Sb (antimony) to a silicon raw material before (or after) melting the silicon raw material. The range of the required resistivity of a silicon wafer for an IGBT is 10 to 1000 $\Omega$cm, and the content of the n-type dopant is adjusted so as to satisfy the above resistivity range. Moreover, the horizontal magnetic field 29 is generated by passing current in the same direction through the first and second coils 31 and 32. The magnetic field intensity of the horizontal magnetic field 29 is measured at a point of intersection of the surface of the silicon melt 15 and the central axis of the crucible 13, and the current passing through the first and second coils 31 and 32 is controlled such that the magnetic field intensity becomes 0.2 T (tesla) or more. Here, the magnetic field intensity is limited to 0.2 T or more because a magnetic field intensity of less than 0.2 T reduces the effect of reducing the amount of oxygen taken up by the silicon single crystal 11. However, since too high a magnetic field intensity may hasten degradation of the inner surface of the inner case 13a of the crucible 13 and cause dislocation in the single crystal 11, it is desirable that the magnetic field intensity be set at 0.5 T or less.

Next, the silicon single crystal 11 is grown such that COPs appear under the condition that satisfies a relation $Gc/Ge \geq 1$ when, of the temperature gradients in the pulling direction of the single crystal 11 in the temperature range where the temperature of the center of the silicon single crystal 11 to be grown by using the growth apparatus described above is from the melting point to 1370°C, the temperature gradient at the center of the single crystal 11 is Gc and the temperature gradient on the periphery of the single crystal 11 is Ge. Here, the reason the silicon single crystal 11 is grown such that COPs appear under the condition that satisfies a relation $Gc/Ge \geq 1$ is to obtain a single crystal 11 in which COPs are small in size and the density thereof is low. Specifically, a single crystal 11 including a region where COPs having a size of 100 nm or less and a density of $3 \times 10^6$ counts/cm$^3$ or below, preferably $1 \times 10^6$ counts/cm$^3$ or below, appear in the single crystal 11 is grown. Here, the sizes of the COPs in the single crystal 11 are limited to 100 nm or less because, when the COPs are greater than that size, it becomes harder for the COPs to disappear even when high-temperature oxidizing heat treatment is performed, and the density of the COPs in the single crystal 11 is limited to $3 \times 10^6$ counts/cm$^3$ or below because, when the density exceeds $3 \times 10^6$ counts/cm$^3$, the number of COPs which do not disappear even after oxidizing heat treatment is increased due to the high density of the COPs.

Furthermore, the rotation speed of the crucible 13 during the growth of the silicon single crystal 11 is set at 1.5 rpm or less, preferably 0.3 rpm or less, and the rotation speed of the silicon single crystal 11 during the growth is set at 7 rpm or less, preferably 5 rpm or less. Here, the rotation speed of the crucible 13 is limited to 1.5 rpm or less and the rotation speed of the silicon single crystal 11 is limited to 7 rpm or less in order to keep the concentration of interstitial oxygen of the silicon single crystal 11 at a concentration of $6 \times 10^{17}$ atoms/cm$^3$ or below and keep variation in radial in-plane resistivity in the silicon single crystal 11 at 5 % or less even when the silicon single crystal 11 is pulled upward from the silicon melt 15 containing the n-type dopant. Incidentally, it is desirable to set a lower limit of the rotation speed of the silicon single crystal 11 at 0.5 rpm or more. When the rotation speed of the silicon single crystal 11 is slower than 0.5 rpm, deformation appears in the silicon single crystal 11 or the in-plane resistivity distribution is worsened. As described above, the shape of the solid-liquid interface between the single crystal 11 and the silicon melt 15 is flattened by adopting the condition that satisfies a relation $Gc/Ge \geq 1$. In this state, by applying the horizontal magnetic field 29 to the silicon melt 15, slowing down the rotation speed of the crucible 13, and slowing down the rotation speed of the single crystal 11, it is possible to reduce the concentration of interstitial oxygen in the single crystal 11 while maintaining a uniform radial n-type dopant concentration distribution of the single crystal 11.

By producing the silicon single crystal 11 in the manner described above, the concentration of interstitial oxygen in the single crystal 11 is set at $6 \times 10^{17}$ atoms/cm$^3$ or below, preferably $4 \times 10^{11}$ atoms/cm$^3$ or below. Incidentally, the concentration of interstitial oxygen in the present specification is a measurement value measured by Fourier transform infrared spectrophotometry standardized in ASTM F-121 (1979). Here, the concentration of interstitial oxygen in the single crystal 11 is limited to $6 \times 10^{17}$ atoms/cm$^3$ or below because, when the concentration of interstitial oxygen exceeds

$6 \times 10^{17}$ atoms/cm$^3$, a problem arises, such as a reduction in a recombination lifetime due to formation of oxygen precipitates in the single crystal 11 or fluctuations in the resistivity caused by formation of oxygen donors, making it difficult to eliminate the COPs by oxidizing heat treatment. Moreover, variation in radial in-plane resistivity in the single crystal 11 is set at 5 % or less, preferably 4 % or less. Here, by setting variation in radial in-plane resistivity in the single crystal 11 at 5 % or less, it is possible to stabilize the quality of IGBTs, and this helps enhance yield in a device process.

A silicon wafer obtained by slicing the above-described single crystal 11 is subjected to heat treatment by which the silicon wafer is heated in an atmosphere of oxygen gas to a predetermined temperature in the range of 1100 to 1300°C, preferably 1150 to 1200°C, and is maintained at this predetermined temperature for 2 to 5 hours, preferably 3 to 4 hours. This makes it possible to eliminate the COPs throughout the entire area of the wafer in the radial and thickness directions. Here, the temperature at which the wafer is maintained by the heat treatment is limited to the range of 1100 to 1300°C because a temperature of less than 1100°C makes it harder for the COPs to disappear; on the other hand, a temperature of more than 1300°C makes a heat load imposed on the wafer too large, resulting in the occurrence of slip dislocation or the like in the wafer. Furthermore, the time for which the wafer is subjected to the heat treatment is limited to the range of 2 to 5 hours because less than 2 hours make it impossible to eliminate the COPs adequately; on the other hand, heat treatment performed for more than 5 hours does not greatly change the effectiveness in eliminating the COPs.

EXAMPLES

Next, examples of the invention will be described in detail along with comparative examples.

Example 1

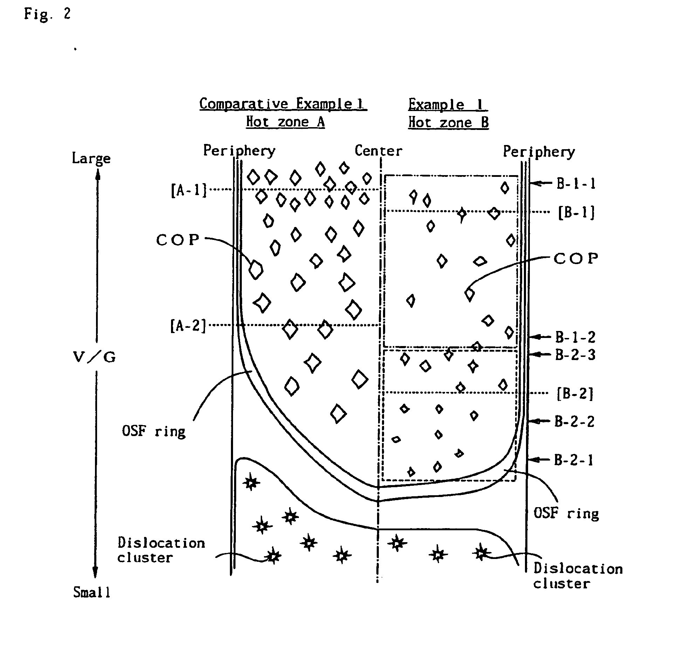

Under the condition satisfying a relation Gc/Ge = 1.2 when, of the temperature gradients in the pulling direction of the single crystal 11 in the temperature range where the temperature of the center of the silicon single crystal 11 to be grown by using the growth apparatus shown in FIG. 1 was from the melting point to 1370°C, the temperature gradient at the center of the single crystal 11 was Gc and the temperature gradient on the periphery of the single crystal 11 was Ge, that is, in a hot zone B of FIG. 2, the single crystal 11 was grown by gradually slowing down the pulling rate. Here, a silicon single crystal in which the concentration of interstitial oxygen was $13 \times 10^{11}$ atoms/cm$^3$ and a silicon single crystal in which the concentration of interstitial oxygen was $3 \times 10^{17}$ atoms/cm$^3$ were grown by obtaining the silicon melt 15 containing phosphorus by adding phosphorus to a silicon raw material before melting the silicon raw material such that the radial in-plane resistivity at the top of a straight body of a grown single crystal 11 became 100 Ωcm and applying a horizontal magnetic field of 0.3 T to the silicon melt 15 in the crucible 13. The concentration of interstitial oxygen was measured in accordance with Fourier transform infrared spectrophotometry standardized in ASTM F-121 (1979).

On the other hand, in order to check the defect distribution in the single crystal, it was necessary to examine the occurrence distribution of an OSF ring. Therefore, to examine the occurrence distribution of an OSF ring, a silicon single crystal containing a high concentration of oxygen (oxygen concentration: $13 \times 10^{17}$ atoms/cm$^3$) was grown by design. Based on the results thus obtained, the defect distribution of a silicon single crystal containing a low concentration of oxygen (oxygen concentration: $3 \times 10^{17}$ atoms/cm$^3$) was estimated. In this case, other specifications were the same except for the different oxygen concentrations. Specifically, the diameter of the single crystal was set at 210 mm, the crystal orientation was set at <100>, and the length of the straight body of the single crystal was set at 1700 mm. Furthermore, since a region where an OSF ring had occurred, the region located on the outermost periphery of the single crystal, could not be removed (eliminated) no matter how fast the pulling rate of the single crystal became, the region where the OSF ring had occurred existed on the outermost periphery of the single crystal. However, this OSF-ring region would be removed by subsequent rounding of the single crystal, that is, by cutting the outer circumferential surface of the single crystal in such a way that the diameter of the single crystal was reduced from 210 mm to 200 mm. Therefore, the diameter of the actually grown single crystal was made larger than a target diameter.

Comparative Example 1

A silicon single crystal was grown under the same condition as in Example 1 except that a silicon single crystal growth apparatus (not shown) having a hot zone obtained by adjusting the placement and structures of the structural parts (such as a heat insulating material and a heat shield) inside a furnace so as to promote cooling in the temperature range where the temperature of the center of a single crystal to be grown was from the melting point to 1370°C, that is, a hot zone A of FIG. 2, the hot zone A satisfying a relation Gc < Ge, specifically, a relation Gc/Ge = 0.98, was used.

Comparative Test 1 and Evaluation

Evaluation samples were prepared by longitudinally cleaving single crystals containing a high concentration of oxygen of $13 \times 10^{17}$ atoms/cm$^3$, the single crystals of the silicon single crystals grown by the growth apparatuses of Example 1 and Comparative Example 1. Then, heat treatment for evaluating oxygen precipitates was performed on these evaluation samples. Specifically, heat treatment by which the evaluation samples were maintained at 800°C in an oxidizing atmosphere for 4 hours and then maintained at 1000°C for 16 hours was performed. Next, defects were exposed on the outside of the surfaces of the evaluation samples subjected to the heat treatment by the copper decoration technique. Specifically, defects on the surfaces of the evaluation samples were exposed on the outside of the surfaces by cooling the evaluation samples rapidly after diffusing copper into the evaluation samples by contaminating the surfaces of the evaluation samples with copper and then performing heat treatment by which the evaluation samples were maintained at 1000°C for 1 hour. Furthermore, selective etching was performed on the rapidly-cooled evaluation samples by using Wright etchant, and pits that appeared on the surfaces of the evaluation samples were observed by an optical microscope. The results thus obtained are shown in FIG. 2.

It was clear from FIG. 2 that, in the hot zone B of Example 1, as shown in the right side of FIG. 2, an OSF ring was roughly in the form of the letter U and rapidly shrank toward the center when V/G had become small; in the hot zone A of Comparative Example 1, as shown in the left side of FIG. 2, an OSF ring was roughly in the form of the letter V and gradually shrank toward the center as V/G became small. Moreover, it was found that the hot zone B of Example 1 and the hot zone A of Comparative Example 1 greatly differed in the size and density of distribution of the COPs in the COP region, and that, in the evaluation sample in the hot zone A of Comparative Example 1, while the COPs became reduced in size as the pulling rate was increased, the density of the COPs became high; on the other hand, in the evaluation sample in the hot zone B of Example 1, the slower the pulling rate, the smaller the COPs in size and the lower the density of the COPs.

Example 2

A wafer was cut from a part of a silicon single crystal containing a low concentration of oxygen ($3 \times 10^{17}$ atoms/cm$^3$), the part corresponding to a [B-2] region in the hot zone B on the right side of FIG. 2, the hot zone B obtained in Comparative Test 1 described above by longitudinally cleaving the single crystal containing a high concentration of oxygen ($13 \times 10^{17}$ atoms/cm$^3$) and exposing the defects on the surface of the evaluation sample on the outside of the surface. The wafer thus obtained was treated as Example 2. Incidentally, the [B-2] region means a region where a COP located close to the OSF ring has appeared (a slow pulling rate condition).

Comparative Example 2

A wafer was cut from a part of a silicon single crystal containing a low concentration of oxygen ($3 \times 10^{17}$ atoms/cm$^3$), the part corresponding to a [A-1] region in the hot zone A on the left side of FIG. 2, the hot zone A obtained in Comparative Test 1 described above by longitudinally cleaving the single crystal containing a high concentration of oxygen ($13 \times 10^{17}$ atoms/cm$^3$) and exposing the defects on the surface of the evaluation sample on the outside of the surface. The wafer thus obtained was treated as Comparative Example 2. Incidentally, the [A-1] region means a region where a COP located away from the OSF ring has appeared (a fast pulling rate condition).

Comparative Example 3

A wafer was cut from a part of a silicon single crystal containing a low concentration of oxygen ($3 \times 10^{17}$ atoms/cm$^3$), the part corresponding to a [A-2] region in the hot zone A on the left side of FIG. 2, the hot zone A obtained in Comparative Test 1 described above by longitudinally cleaving the single crystal containing a high concentration of oxygen ($13 \times 10^{17}$ atoms/cm$^3$) and exposing the defects on the surface of the evaluation sample on the outside of the surface. The wafer thus obtained was treated as Comparative Example 3. Incidentally, the [A-2] region means a region where a COP located close to the OSF ring has appeared (a slow pulling rate condition).

Comparative Example 4

A wafer was cut from a part of a silicon single crystal containing a low concentration of oxygen ($3 \times 10^{17}$ atoms/cm$^3$), the part corresponding to a [B-1] region in the hot zone B on the right side of FIG. 2, the hot zone B obtained in Comparative Test 1 described above by longitudinally cleaving the single crystal containing a high concentration of oxygen ($13 \times 10^{17}$ atoms/cm$^3$) and exposing the defects on the surface of the evaluation sample on the outside of the surface. The wafer thus obtained was treated as Comparative Example 4. Incidentally, the [B-1] region means a region where a COP located away from the OSF ring has appeared (a fast pulling rate condition).

Comparative Test 2 and Evaluation

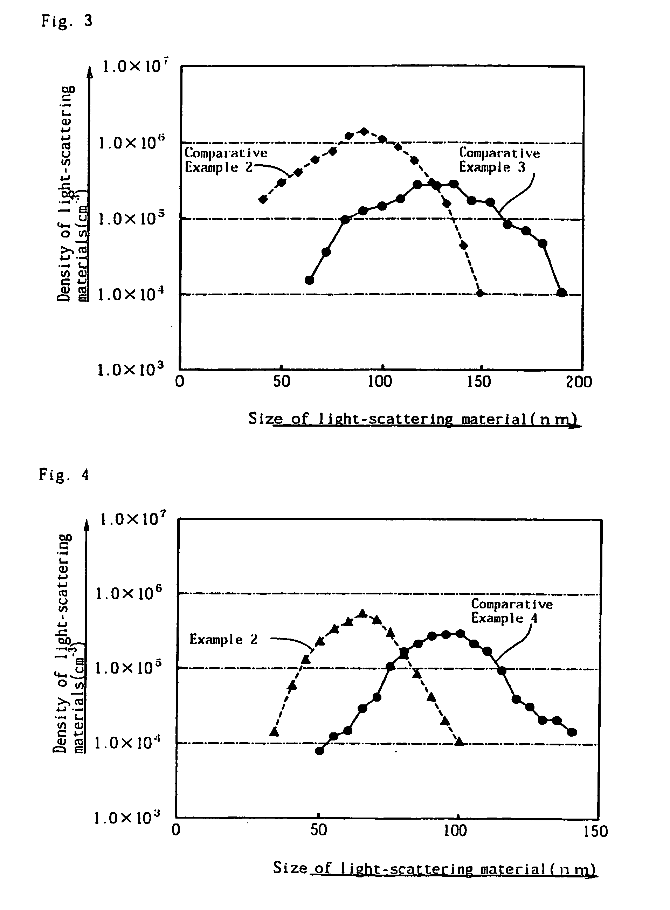

The size and density of the COPs in the wafers of Example 2 and Comparative Examples 2 to 4 were measured. Specifically, the size and density of distribution of the COPs of each wafer were measured by using an infrared scattering tomograph (MO441 manufactured by Mitsui Mining & Smelting Co., Ltd.). The results thus obtained are shown in FIGS. 3 and 4. Incidentally, the COPs were measured as light-scattering materials by the infrared scattering tomograph. That is, the density of the light-scattering materials in the vertical axis of FIGS. 3 and 4 means the density of the COPs.

As clearly shown in FIG. 3, in the wafer of Comparative Example 2 (the wafer in the [A-1] region and grown under the fast pulling rate condition), the size of the COP was small but the density thereof was high. Moreover, in the wafer of Comparative Example 3 (the wafer in the [A-2] region and grown under the slow pulling rate condition), the density of the COPs was low but the size thereof was large. Furthermore, although the size of the COP of the wafer of Comparative Example 2 was smaller than that of the wafer of Comparative Example 3, more than half of the COPs of the wafer of Comparative Example 2 exceeded 100 nm in size. On the other hand, as clearly shown in FIG. 4, in the wafer of Comparative Example 4 (the wafer in the [B-1] region and grown under the fast pulling rate condition), the density of the COPs was low but the size thereof was large; by contrast, in the wafer of Example 2 (the wafer in the [B-2] region and grown under the slow pulling rate condition), the COPs were small in size and contained no COPs larger than 100 nm, and the density thereof was $3 \times 10^6$ counts/cm$^3$ or below.

Comparative Test 3 and Evaluation

The V/G range when a silicon single crystal was grown by using the growth apparatuses of Example 1 and Comparative Example 1 was examined. Specifically, the condition under which the [B-2] region of Example 2 could be obtained, that is, the V/G (mm$^2$/ (min·°C) range in which a crystal region where the size of the COP was 100 nm or less and the density thereof was $3 \times 10^6$ counts/cm$^3$ or below could be obtained was examined. Here, V is a pulling rate (mm/min), and G is a temperature gradient (°C/mm) in the pulling shaft direction near the solid-liquid interface. As a result, the V/G range where the [B-2] region of Example 2 could be obtained was between 0.23 and 0.33 (mm$^2$/ (min·°C). The above V/G range was obtained by heat-transfer calculation using a computer. Incidentally, a region surrounded by a broken line in FIG. 2 is the schematic range of a crystal region having the same COP characteristics as those of the [B-2] region of Example 2, that is, the crystal region where the size of the COP is 100 nm or less and the density thereof is $3 \times 10^6$ counts/cm$^3$ or below. On the other hand, a region surrounded by a chain double-dashed line in FIG. 2 is the schematic range of a crystal region having the same COP characteristics as those of the [B-1] region of Comparative Example 4, that is, the crystal region where the size of the COP is 100 nm or less but the density thereof is not $3 \times 10^6$ counts/cm$^3$ or below.

Comparative Test 4 and Evaluation

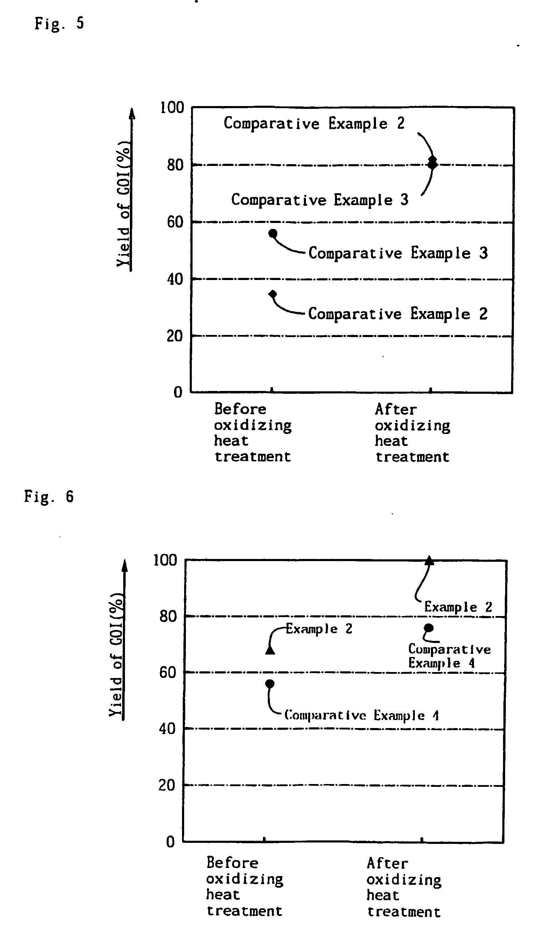

Oxidizing heat treatment by which a wafer was maintained at 1100°C in an atmosphere of 100 % oxygen gas for 4 hours was performed on the wafers of Example 2 and Comparative Examples 2 to 4. The yield of GOI before and after the oxidizing heat treatment was obtained by TZDB (time zero dielectric breakdown). After a MOS (metal oxide semiconductor) structure was fabricated by forming a gate oxide film (an oxide film) and an electrode on a silicon wafer, the gate oxide film was broken down by applying a voltage to the electrode, and the breakdown voltage was measured, whereby the yield of GOI was obtained. Here, an electrical breakdown of the gate oxide film was produced in a defect portion of the wafer. Incidentally, the withstand voltage of the gate oxide film was specifically measured by TZDB as follows. First, a gate oxide film (SiO$_2$) having a thickness of 25 nm was formed on the front surface of the wafer. Next, a polysilicon electrode having a gate electrode area of 10 mm$^2$ was formed on the gate oxide film. Then, a voltage is applied between the wafer and the polysilicon electrode by step voltage application, and a voltage having a determination field intensity of 11 MV/cm was eventually applied. The measurement temperature was set at room temperature (25°C). The results thus obtained are shown in FIGS. 5 and 6.

As clearly shown in FIGS. 5 and 6, in the wafers of Comparative Examples 2 to 4, although the yield of GOI was slightly improved by the oxidizing heat treatment, the yield of GOI after the oxidizing heat treatment was about 80 % in any of these wafers. By contrast, in the wafer of Example 2, the yield of GOI was increased to 100 %. Moreover, when the wafers of Comparative Example 4 and Example 2 after the oxidizing heat treatment were checked for COPs by using an infrared scattering tomograph (MO441 manufactured by Mitsui Mining & Smelting Co., Ltd.), the COPs were observed in the wafer of Comparative Example 4, but no COPs were observed in the wafer of Example 2.

Example 3

A wafer was cut from a part of a silicon single crystal containing a low concentration of oxygen ($3 \times 10^{17}$ atoms/cm$^3$), the part corresponding to a [B-2-1] region in the hot zone B on the right side of FIG. 2, the hot zone B obtained in Comparative Test 1 described above by longitudinally cleaving the single crystal containing a high concentration of oxygen ($13 \times 10^{11}$ atoms/cm$^3$) and exposing the defects on the surface of the evaluation sample on the outside of the surface. The wafer thus obtained was treated as Example 3. Incidentally, the [B-2-1] region means that a region where a COP has appeared, an OSF ring, and a non-defect region are present in this order from the center to the periphery of the single crystal in the radial direction.

Example 4

A wafer was cut from a part of a silicon single crystal containing a low concentration of oxygen ($3 \times 10^{17}$ atoms/cm$^3$), the part corresponding to a [B-2-2] region in the hot zone B on the right side of FIG. 2, the hot zone B obtained in Comparative Test 1 described above by longitudinally cleaving the single crystal containing a high concentration of oxygen ($13 \times 10^{17}$ atoms/cm$^3$) and exposing the defects on the surface of the evaluation sample on the outside of the surface. The wafer thus obtained was treated as Example 4. Incidentally, the [B-2-2] region means that a region where a COP has appeared is present in the center of the single crystal in the radial direction and an OSF ring is present on the periphery thereof in the radial direction.

Example 5

A wafer was cut from a part of a silicon single crystal containing a low concentration of oxygen ($3 \times 10^{17}$ atoms/cm$^3$), the part corresponding to a [B-2-3] region in the hot zone B on the right side of FIG. 2, the hot zone B obtained in Comparative Test 1 described above by longitudinally cleaving the single crystal containing a high concentration of oxygen ($13 \times 10^{17}$ atoms/cm$^3$) and exposing the defects on the surface of the evaluation sample on the outside of the surface. The wafer thus obtained was treated as Example 5. Incidentally, the [B-2-3] region means that a COP region is present all over the single crystal in the radial direction.

Comparative Example 5

A wafer was cut from a part of a silicon single crystal containing a low concentration of oxygen ($3 \times 10^{17}$ atoms/cm$^3$), the part corresponding to a [B-1-1] region in the hot zone B on the right side of FIG. 2, the hot zone B obtained in Comparative Test 1 described above by longitudinally cleaving the single crystal containing a high concentration of oxygen ($13 \times 10^{17}$ atoms/cm$^3$) and exposing the defects on the surface of the evaluation sample on the outside of the surface. The wafer thus obtained was treated as Comparative Example 5. Incidentally, the [B-1-1] region means a region where a COP has appeared, the region on the fast pulling rate side of the [B-1] region (the region having a COP density of more than $3 \times 10^6$ counts/cm$^3$).

Comparative Example 6

A wafer was cut from a part of a silicon single crystal containing a low concentration of oxygen ($3 \times 10^{17}$ atoms/cm$^3$), the part corresponding to a [B-1-2] region in the hot zone B on the right side of FIG. 2, the hot zone B obtained in Comparative Test 1 described above by longitudinally cleaving the single crystal containing a high concentration of oxygen ($13 \times 10^{17}$ atoms/cm$^3$) and exposing the defects on the surface of the evaluation sample on the outside of the surface. The wafer thus obtained was treated as Comparative Example 6. Incidentally, the [B-1-2] region means a region where a COP has appeared, the region on the slow pulling rate side of the [B-1] region (the region located closer to the [B-2] region).

Comparative Test 5 and Evaluation

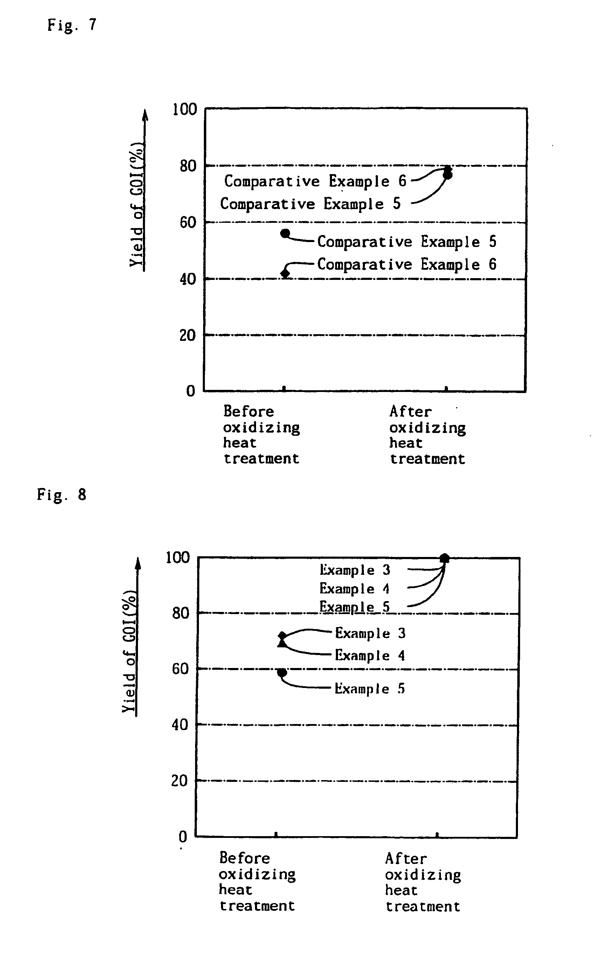

For the wafers of Examples 3 to 5 and Comparative Examples 5 and 6, the yield of GOI was obtained in the same manner as in Comparative Test 4 described above. Comparative Test 5 was conducted to verify the effectiveness of each crystal region. The results thus obtained are shown in FIGS. 7 and 8. As clearly shown in FIG. 7, in either of Comparative Examples 5 and 6, the yield of GOI after the oxidizing heat treatment was low and about 80 %; by contrast, in any of the wafers of Examples 3 to 5, the yield of GOI after the oxidizing heat treatment was increased to 100 %. Moreover, when the wafers of Examples 3 to 5 after the oxidizing heat treatment were checked for COPs by using an infrared scattering tomograph (MO441 manufactured by Mitsui Mining & Smelting Co., Ltd.), COPs were observed in none of the wafers of these examples.

Example 6

A silicon single crystal was grown under the same V/G condition as in the preparation of the wafer of Example 2. The silicon single crystal thus obtained was treated as Example 6. Incidentally, the conditions were the same as those under which the wafer of Example 2 was obtained by slicing the silicon single crystal prepared by using the growth apparatus of Example 1 except that V/G was maintained constant.

Comparative Test 6 and Evaluation

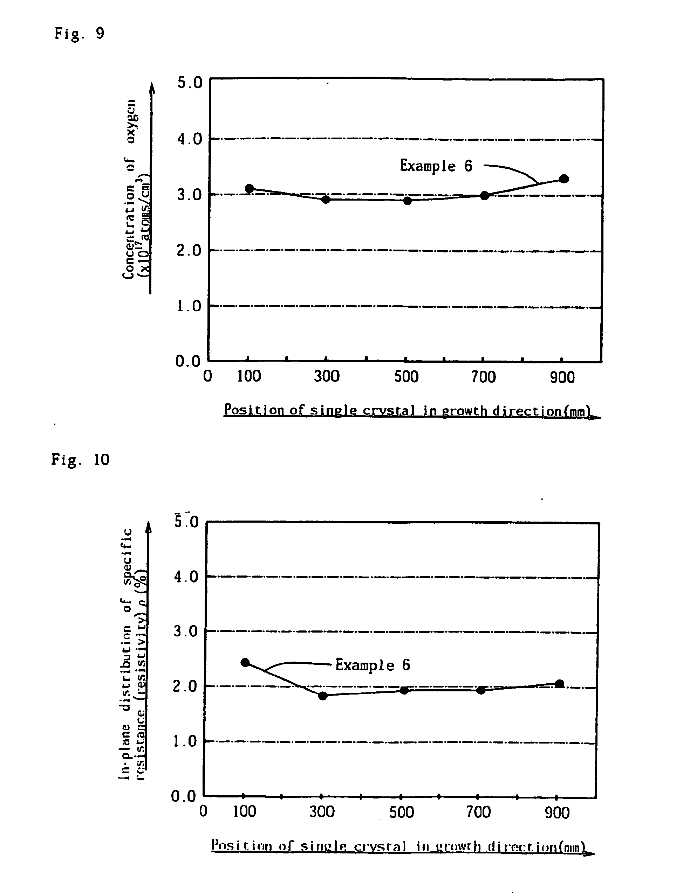

Variation in radial specific resistance (resistivity) p of the silicon single crystal of Example 6 and the distribution of oxygen concentration in the pulling shaft direction were measured. The results thus obtained are shown in FIGS. 9 and 10. As clearly shown in FIGS. 9 and 10, irrespective of the position of the single crystal in the growth direction (the distance over which the straight body was pulled upward), the concentration of oxygen in the single crystal was found to be uniform, and, although the distribution of radial specific resistance (resistivity) p of the single crystal slightly fluctuated at the top of the single crystal, the distribution was found within a target variation range of 5 %.

Comparative Test 7 and Evaluation

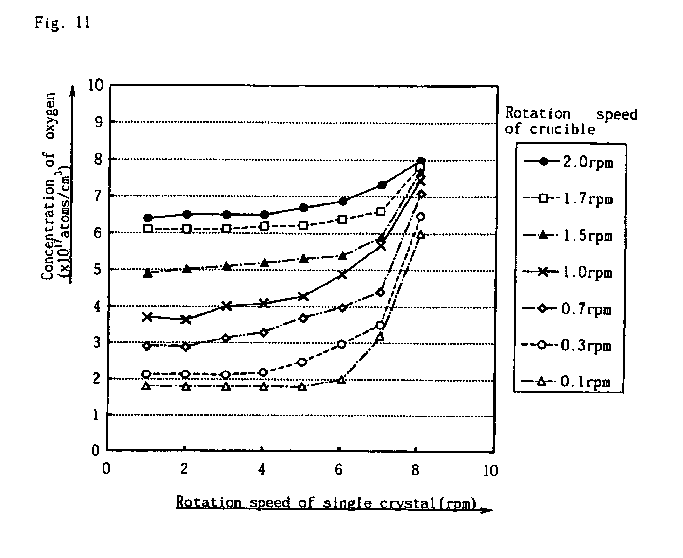

The silicon single crystal 11 was grown by using the growth apparatus shown in FIG. 1. The hot zone B of FIG. 2 was used, the hot zone B satisfying a relation Gc/Ge ≥ 1, specifically, a relation Gc/Ge = 1.2, when, of the temperature gradients in the pulling shaft direction of the single crystal 11 in the temperature range where the temperature of the center of the silicon single crystal 11 during growth was from the melting point to 1370°C, the temperature gradient at the center of the single crystal 11 was Gc and the temperature gradient on the periphery of the single crystal 11 was Ge. Moreover, the pulling rate was adjusted such that V/G fell within the range of 0.23 to 0.33. Furthermore, the silicon melt 15 containing phosphorus was obtained by adding phosphorus to a silicon raw material before melting the silicon raw material such that the radial in-plane resistivity at the top of a straight body of the grown single crystal 11 became 100 Ωcm, and a horizontal magnetic field of 0.2 T was added to the silicon melt 15 in the crucible 13. In addition, the diameter of the single crystal was 210 mm, the crystal orientation of the single crystal was <100>, and the length of the straight body of the single crystal was 1700 mm. On the other hand, the silicon single crystal was grown while rotating the crucible and the single crystal in opposite directions by setting the rotation speed of the crucible in seven levels; 0.1 rpm, 0.3 rpm, 0.7 rpm, 1.0 rpm, 1.5 rpm, 1.7 rpm, and 2.0 rpm, and setting the rotation speed of the single crystal in eight levels, from 1 rpm to 8 rpm. The concentration of interstitial oxygen in the wafer cut from the silicon single crystal thus obtained at a position 200 mm from the top of the straight body thereof was measured. The concentration of interstitial oxygen was measured in accordance with Fourier transform infrared spectrophotometry standardized in ASTM F-121 (1979). The results thus obtained are shown in FIG. 11.

As clearly shown in FIG. 11, when the rotation speed of the crucible was 1.5 rpm or less and the rotation speed of the single crystal was 7 rpm or less, it was possible to reduce the concentration of interstitial oxygen in the wafer to $6.0 \times 10^{17}$ atoms/cm$^3$ or below.

**Claims**

1. A method for growing a silicon single crystal, the method by which silicon melt is stored in a crucible housed in a chamber under inert gas and a silicon single crystal is grown from a seed crystal by immersing the seed crystal in the silicon melt and pulling the seed crystal upward therefrom while rotating the seed crystal, wherein
   the silicon melt stored in the crucible contains n-type dopant,
   a horizontal magnetic field of 0.2 T or more is applied to the silicon melt in the crucible,
   a rotation speed of the crucible is 1.5 rpm or less,
   a rotation speed of the silicon single crystal during growth is 7 rpm or less, and
   the silicon single crystal is grown under a condition satisfying the relation Gc/Ge ≥ 1 when, the temperature gradients in the pulling direction of the silicon single crystal being in a temperature range where the temperature of the center of the silicon single crystal during growth is from the melting point to 1370°C, the temperature gradient at the center of the silicon single crystal during growth is Gc and the temperature gradient on the periphery of the silicon single crystal during growth is Ge,
   a concentration of interstitial oxygen in the silicon single crystal is $6.0 \times 10^{17}$ atoms/cm$^3$ or below,
   variation in radial in-plane resistivity of the silicon single crystal is 5 % or less, and

the silicon single crystal includes a region where COPs have appeared, the COPs having a size of 100 nm or less and a density of $3 \times 10^6$ counts/cm$^3$ or below.

2. A method for producing a silicon wafer, wherein
COPs are eliminated throughout an entire area of the silicon wafer by performing heat treatment on the silicon wafer obtained by slicing a silicon single crystal grown by the method according to claim 1, the heat treatment by which the silicon wafer is heated in an atmosphere of oxygen gas to a predetermined temperature in a range of 1100 to 1300°C and is maintained at the predetermined temperature for 2 to 5 hours.

**Patentansprüche**

1. Verfahren zum Züchten eines Silizium-Einkristalls, bei dem eine Siliziumschmelze in einem Tiegel, der in einer Kammer unter Inertgas untergebracht ist, aufbewahrt wird, und ein Silizium-Einkristall aus einem Impfkristall gezüchtet wird durch Eintauchen des Impfkristalls in die Siliziumschmelze und Ziehen des Impfkristalls daraus nach oben unter Drehen des Impfkristalls, wobei
die in dem Tiegel aufbewahrte Siliziumschmelze Dotierungsmittel vom n-Typ enthält, ein horizontales Magnetfeld von 0,2 T oder mehr an die Siliziumschmelze in dem Tiegel angelegt wird,
die Drehgeschwindigkeit des Tiegels 1,5 Upm oder weniger beträgt,
die Drehgeschwindigkeit des Silizium-Einkristalls während des Wachsens 7 Upm oder weniger beträgt, und
der Silizium-Einkristall unter einer Bedingung gezüchtet wird, die die Beziehung Gc/Ge ≥ 1 erfüllt, wenn, wobei die Temperaturgradienten in der Zugrichtung des Silizium-Einkristalls in einem Temperaturbereich sind, in dem die Temperatur des Zentrum des Silizium-Einkristalls während des Wachstums vom Schmelzpunkt bis zu 1370°C beträgt, der Temperaturgradient in dem Zentrum des Silizium-Einkristalls während des Wachstums Gc ist, und der Temperaturgradient an dem Rand des Silizium-Einkristalls während des Wachstums Ge ist,
eine Konzentration an Zwischengitter-Sauerstoff in dem Silizium-Einkristall beträgt $6,0 \times 10^{17}$ Atome/cm$^3$ oder darunter,
die Variation des spezifischen Widerstands radial in der Ebene des Silizium-Einkristalls beträgt 5 % oder weniger, und
der Silizium-Einkristall enthält einen Bereich, in dem COPs aufgetreten sind, wobei die COPs eine Größe von 100 nm oder weniger und eine Dichte von $3 \times 10^6$ Zählern/cm$^3$ oder darunter haben.

2. Verfahren zur Herstellung eines Silizium-Wafers, bei dem
COPs überall in einem gesamten Bereich des Silizium-Wafers beseitigt werden durch Durchführen einer Wärmebehandlung an dem Silizium-Wafer, der erhalten wurde durch In-Scheiben-Schneiden eines Silizium-Einkristalls, der gezüchtet wurde durch das Verfahren gemäß Anspruch 1, wobei die Wärmebehandlung eine ist, bei der der Silizium-Wafer in einer Sauerstoffgas-Atmosphäre auf eine vorbestimmte Temperatur in einem Bereich von 1100 bis 1300°C erhitzt wird und 2 bis 5 Stunden lang bei der vorbestimmten Temperatur gehalten wird.

**Revendications**

1. Procédé pour faire croître un monocristal de silicium, le procédé par lequel une masse fondue de silicium est stockée dans un creuset reçu dans une chambre sous un gaz inerte et un monocristal de silicium est amené à croître depuis un cristal formant germe par immersion du cristal formant germe dans la masse fondue de silicium et tirage du cristal formant germe vers le haut depuis celle-ci tandis que le cristal formant germe est amené à tourner, où
la masse fondue de silicium stockée dans le creuset contient un dopant de type n,
un champ magnétique horizontal de 0,2 T ou plus est appliqué à la masse fondue de silicium dans le creuset,
une vitesse de rotation du creuset est 1,5 tr/min ou moins,
une vitesse de rotation du monocristal de silicium pendant la croissance est 7 tr/min ou moins et
le monocristal de silicium est amené à croître dans des conditions satisfaisant une relation Gc/Ge ≥ 1 quand, les gradients de température dans la direction de tirage du monocristal de silicium étant dans une plage de température où la température du centre du monocristal de silicium pendant la croissance est du point de fusion à 1370°C, le gradient de température du centre du monocristal de silicium pendant la croissance est Gc et le gradient de température sur la périphérie du monocristal de silicium pendant la croissance est Ge
une concentration d'oxygène interstitiel dans le monocristal de silicium est $6,0 \times 10^{17}$ atomes/cm$^3$ ou inférieure,
la variation de résistivité radiale dans le plan du monocristal de silicium est 5 % ou moins, et
le monocristal de silicium inclut une région où des COP sont apparues, les COP ayant une taille de 100 nm ou moins et une densité de $3 \times 10^6$ coups/cm$^3$ ou inférieure.

2. Procédé pour produire une plaque de silicium où
les COP sont éliminées dans une zone entière de la plaque de silicium par la mise en oeuvre d'un traitement thermique sur la plaque de silicium obtenue par tranchage d'un monocristal de silicium amené à croître par le procédé selon la revendication 1, le traitement thermique par lequel la plaque de silicium est chauffée dans une atmosphère de gaz oxygène à une température prédéterminée dans une plage de 1100 à 1300°C et est maintenue à la température prédéterminée pendant 2 à 5 heures.

EP 2 226 412 B1

Fig. 1

14

Fig. 2

Fig. 3

Density of light-scattering materials(cm⁻³)

Comparative
Example 2

Comparative
Example 3

Size of light-scattering material(n m)

Fig. 4

Density of light-scattering materials(cm⁻³)

Example 2

Comparative
Example 4

Size of light-scattering material(n m)

Fig. 5

Fig. 6

Fig. 7

Fig. 8

Fig. 9

Fig. 10

Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007254274 A

- WO 2004073057 A